(19) Europäisches Patentamt
European Patent Office
Office européen des brevets

(11) **EP 1 788 647 B1**

(12) **EUROPÄISCHE PATENTSCHRIFT**

(45) Veröffentlichungstag und Bekanntmachung des Hinweises auf die Patenterteilung:
**26.11.2008 Patentblatt 2008/48**

(51) Int Cl.:
***H01L 51/52*** *(2006.01)*      ***H01L 27/32*** *(2006.01)*

(21) Anmeldenummer: **05025417.6**

(22) Anmeldetag: **22.11.2005**

(54) **Licht emittierendes Bauteil**

Light emitting device

Dispositif électroluminescent

(84) Benannte Vertragsstaaten:
**AT BE BG CH CY CZ DE DK EE ES FI FR GB GR HU IE IS IT LI LT LU LV MC NL PL PT RO SE SI SK TR**

(43) Veröffentlichungstag der Anmeldung:
**23.05.2007 Patentblatt 2007/21**

(73) Patentinhaber: **Novaled AG**
**01307 Dresden (DE)**

(72) Erfinder:
 • **Werner, Ansgar**
  **01277 Dresden (DE)**
 • **Vehse, Martin**
  **01324 Dresden (DE)**
 • **Wellmann, Philipp**
  **01277 Dresden (DE)**

(74) Vertreter: **Bittner, Thomas L.**
**Forrester & Boehmert**
**Pettenkoferstrasse 20-22**
**80336 München (DE)**

(56) Entgegenhaltungen:
**EP-A- 1 052 708**      **EP-A- 1 406 315**
**WO-A-20/04034750**      **US-A1- 2002 090 449**
**US-A1- 2004 164 671**      **US-A1- 2004 169 624**
**US-A1- 2005 196 893**

 • **JAN BLOCHWITZ-NIMOTH ET AL: "29.1: Full Color Active Matrix OLED Displays with High Aperture Ratio" 2004 SID INTERNATIONAL SYMPOSIUM. SEATTLE, WA, MAY 25 - 27, 2004, SID INTERNATIONAL SYMPOSIUM, SAN JOSE, CA : SID, US, 25. Mai 2004 (2004-05-25), Seiten 1000-1003, XP007011891**
 • **ZHOU X ET AL: "High-efficiency electrophosphorescent organic light-emitting diodes with double light-emitting layers" APPLIED PHYSICS LETTERS, AIP, AMERICAN INSTITUTE OF PHYSICS, MELVILLE, NY, US, Bd. 81, Nr. 21, 18. November 2002 (2002-11-18), Seiten 4070-4072, XP012032604 ISSN: 0003-6951**

**Beschreibung**

Die Erfindung betrifft ein Licht emittierendes Bauteil, insbesondere Anzeige- oder Beleuchtungseinrichtung, mit mehreren organischen Bauelementen, die Licht unterschiedlicher Farbe aussendend gebildet sind.

Stand der Technik

Organische Bauelemente, insbesondere in Form organischer Leuchtdioden, die auch als OLEDs (OLED - "Organic Light Emitting Diode") bezeichnet werden, gewinnen in den letzten Jahren verstärkt an Aufmerksamkeit aufgrund ihres hohen Potentials für Anwendungen im Bereich der Beleuchtung und der Displaytechnologie. Hierbei sind unterschiedliche Aspekte organischer Leuchtdioden von Bedeutung, unter anderem ihr Potential für hohe Leistungseffizienzen, ihre brillanten Farben, der starke Hell-Dunkel-Kontrast, schnelle Schaltzeiten und große Füllfaktoren um nur einige Vorteile gegenüber der bisher verbreiteten LCD-Technologie zu nennen. Insbesondere bieten OLEDs in der Display- oder Anzeigetechnologie grundsätzlich neue Ansätze und Möglichkeiten bei der Realisierung von Aktiv- und Passivmatrixanzeigen.

Weiterhin bietet die Kombination von roten, grünen und blauen OLEDs die Basis für eine ganze Anzahl von Bauelementen. So kann beispielsweise mittels linienförmiger Anordnung von OLEDs in den drei Grundfarben und der Verwendung einer Streuscheibe eine Lichtquelle mit einstellbarer Farbe hergestellt werden (siehe EP 1 425 803 A1, DE 101 45 492 A1). Mit Hilfe der individuellen Einstellung der Helligkeit der unterschiedlichen Grundfarben kann jede beliebige Farbe, die im durch die Grundfarben aufgespannten CIE Farbdreieck liegt, erzeugt werden. Neben der Verwendung der OLED als Flächenstrahler zur Beleuchtung, wird jedoch das Hauptverwendungsgebiet der OLED nach wie vor die Realisierung von vollfarbigen organischen Displays / Anzeigen gesehen.

Alle diese Bauelemente haben die Gemeinsamkeit, dass organische Bauelemente, die rotes, grünes und blaues Licht emittieren, nebeneinander auf einem gemeinsamen Substrat angeordnet werden. Auf dem Substrat kann die für Displays notwendige Treiberelektronik bereits integriert sein, auf jeden Fall müssen für die einzelnen OLED-Pixel vorstrukturierte Kontakte und Zuleitungen auf dem Substrat gebildet sein. Auf diesen Grundkontakt eines jeden Pixels werden unterschiedliche organische Schichten mit verschiedenen Funktionen abgeschieden und im Anschluss daran ein zweiter Kontakt aufgebracht.

Die Abstimmung des Stapels organischer Schichten auf die Wellenlänge des zu emittierenden Lichts der OLED hat einen wesentlichen Einfluss auf die Effizienz der jeweiligen OLED. Eine falsche Wahl der organischen Schichtdicken führt dazu, dass die Lage einer Emissionszone, nämlich des Bereiches, in welchem die Ladungsträger (Elektronen, Löcher) unter Abgabe von Licht rekombinieren, nicht auf eine Mikrokavität, d.h. den Abstand zwischen zwei, reflektierenden Grenzflächen zwischen denen der Stapel organischer Schichten angeordnet ist, abgestimmt ist. Die Emissionszone ist innerhalb eines Licht emittierenden Schichtbereiches des Stapels organischer Schichten gebildet. Generell findet die Lichtemission nicht homogen über die Licht emittierende Schicht verteilt statt, sondern je nach Ladungsträgergleichgewicht, in der schmalen Emissionszone. Aufgrund einer falschen Wahl der Mikrokavität kann sich eine Verschlechterung der Auskopplung des erzeugten Lichtes ergeben, was wiederum zu drastische Einbußen in der Effizienz des organischen Bauelementes führt und das gewählte Lumineszenzspektrum verfälschen kann.

Es lassen sich prinzipiell zwei unterschiedliche Bauformen von OLEDs unterscheiden: So genannte "top-emittierende" und "bottom-emittierende" OLEDs. Bei den bottom-emittierenden OLEDs strahlt das von der OLED emittierte Licht durch ein transparentes Substrat hindurch, auf welches das organische Bauelement aufgebracht ist. Bei top-emittierenden OLEDs strahlt das emittierte Licht in die vom Substrat abgewandte Richtung.

Eine typische Bauform der bottom-emittierenden OLED besteht aus einem transparenten Substratmaterial, zum Beispiel Glas, das mit einer transparenten oder semitransparenten Elektrode, die beispielsweise aus Indium-Zinn-Oxid (ITO) besteht, beschichtet wird. Darauf werden die organischen Schichten abgeschieden, und anschließend wird eine reflektierenden Elektrode aufgebracht, die insbesondere als Metallschicht aus Al, Au, Ag, Mg, oder dergleichen gebildet wird.

Bei der top-enuttiercnden OLED ist es nicht notwendig, dass das Substratmaterial transparent ist. Um eine möglichst hohe Effizienz zu erzielen, sollte die auf das Substratmaterial aufgebrachte Elektrode hoch reflektierend sein. Auf die darauf folgenden organischen Schichten ist eine transparente oder semitransparente Elektrode, beispielsweise eine Schicht aus ITO oder eine dünne Metallschicht, aufgebracht.

Die organischen Schichten erfüllen unterschiedliche Funktionen, die zum Betrieb des organischen Bauelementes erforderlich sind. Sie dienen als Injektions- und Transportschichten für Ladungsträger, nämlich Elektronen und Löcher. In der Emissionszone in einem Licht emittierenden Schichtbereich wird durch Rekombination der Ladungsträger unter Aussendung von Photonen Licht erzeugt.

Zwei unterschiedliche organische Schichten sind die Minimalanforderung für eine OLED, bei der die Emissionszone an eine bestimmte Position im Stapel organischer Schichten geschoben werden kann. In diesem Fall finden die Injektion und der Transport von Ladungsträgern einer Polarität, sowie die Lichtemission in jeweils einer Schicht statt.

In technisch anspruchsvolleren organischen Bauelementen werden diese Aufgaben von unterschiedlichen Schichten übernommen, um die Ladungsträgertransportschichten und die Licht emittierende Schicht getrennt voneinander optimieren zu können. Besonders im Falle von dotierten Transportschichten ist es vorteilhaft, weitere Zwischenschichten zwischen Transport- und Emissionsschicht einzufügen, um verschiedene nichtstrahlende Rekombinationsmöglichkeiten auszuschließen und so die Effizienz zu verbessern (DE 100 58 578 C2).

Es ist bekannt, dass bei einem RGB-System (RGB - Rot-Grün-Blau) die einzelnen Stapel organischer Schichten in den organischen Bauelementen auf die jeweilige Emissionsfarbe abgestimmt werden müssen. Hierbei ist es wünschenswert, die Schichtdicken möglichst vieler Schichten im jeweiligen Stapel organischer Schichten der unterschiedlich farbigen OLEDs gleich auszuführen, um sich unnötige Maskenschritte bei der Prozessierung zu ersparen. Im Idealfall sollte sich der Stapel organischer Schichten für die rote, grüne und blaue OLED nur in einer Schicht unterscheiden.

Ein möglicher Ansatz hierfür ist eine Vorstrukturierung des Substrates, bei der eine zusätzliche Zwischenschicht als Abstandhalter auf das Substrat aufgebracht wird (US 5,554,911 B2). Hieraus resultiert jedoch eine umständliche Prozessierung des Substrats und eine unebene Grundfläche, was zu Problemen bei der Display- / Anzeigen-Fertigung führen kann.

Der am häufigsten verwendete Ansatz ist es, die Dicke der Transportschichten zu variieren und somit die Emissionszone an die optimale Position zu schieben. Hierdurch kann neben einer Effizienzsteigerung auch eine Verbesserung der Farbreinheit erzielt werden (US 2003 /0075714 A1). Dies gewährleistet zwar eine ideale Abstimmung der Mikrokavität auf das E-missionsspektrum, hat aber den Nachteil, dass für jede Farbe ein anderer Stapel organischer Schichten gewählt werden muss. Da dies in der Displayproduktion sehr aufwendig ist, muss dann doch auf eine gemeinsame optische Mikrokavitätslänge für alle drei Grundfarben zurückgegriffen werden, bei der ein vertretbarer Kompromiss für die einzelnen Farben erzielt wird, wie in dem Dokument EP 1 154 676 A1 vorgeschlagen wird.

Oft wird als Kompromiss auch eine zusätzliche Zwischenschicht eingefügt, mit der die Mikrokavität so gut wie möglich auf die jeweilige Emissionsfarbe abgestimmt wird. Auch dies setzt wieder einen zusätzlichen Maskierungsschritt voraus. Bei dieser Zusatzschicht kann es sich sowohl um zusätzliche Injektions-, Transport- oder Emitterschichten handeln (US 5,554,911 B2, US 6,541,130 B2 oder US 6,861,800 B2).

Weiterhin wird vorgeschlagen, die Vereinheitlichung des OLED-Stapels dadurch zu erreichen, dass nicht drei unterschiedliche Emittermaterialien in dem jeweiligen Licht emittierenden Schichtbereich für die Grundfarben verwendet werden, sondern für die unterschiedlichen Farbpixel einheitliche, spektral breitbandige Emittermaterialien zu wählen und die farbliche Selektion lediglich mittels Abstimmung der Mikrokavität mit Hilfe einer Zusatzschicht auszuführen (US 5,554,911 B2 oder US 6,861,800 B2).

In den meisten Fällen wird jedoch versucht, das Problem dadurch zu umgehen, dass bei einem RGB-System nur der Stapel organischer Schichten für die Farbe mit der geringsten Effizienz optimiert wird. Zu Verminderung der Effizienzverluste, die sich bei dieser Struktur für die beiden anderen Farben ergeben, wird dann versucht, diese mittels einer zusätzlichen Auskopplungsschicht außerhalb des organischen Bauelementes zu minimieren.

WO 2004/034750 A offenbart ein Licht emittierendes Bauteil mit mehreren organischen Leuchtdioden, wobei die mehreren organischen Leuchtdioden eine Licht emittierende Schicht mit einer an eine Löcher transportierenden Schicht bzw. Elektronen transportierende Schicht Emissionszone umfassen.

Aus US 2004/164671 A1 gehen organische Leuchtdioden mit einem Substrat, einer transparenten Elektrode, einer weiteren Elektrode und wenigstens zwei organischen Schichten, welche eine Licht emittierende Schicht und eine Elektronen transportierende Schicht umfassen, wobei die Dicke der Elektronen transportierenden Schicht größer als 60nm und die Gesamtdicke der Licht emittierenden und der Elektronen transportierenden Schicht kleiner als 90nm betragen.

US 2002/090449 A1 beschreibt ein Verfahren zur Herstellung eines Licht emittierenden Bauteils, bei welchem auf einem transparenten Substrat organische lumineszierende Schichten gebildet werden, welche Licht unterschiedlicher Wellenlängen aussenden können.

In US 2004/0169624 A1 ist eine OLED mit einer transparenten Kathode und einer transparenten Anode offenbart, welche Licht sowohl durch die Anode als auch durch die Kathode aussendet.

Der Artikel von Jan Blochwitz-Nimoth et al: "29.1: Full Color Active Matrix OLED Displays with High Aperture Ratio" 2004 SID International Symposium, Seattle, WA, May 25-27, 2004, SID International Symposium, San Jose, CA: SID, US, 25. May 2004, Seiten 1000-1003 beschreibt die Herstellung einer top-emittierenden OLED mittels gezielt dotierter Ladungsträgertransportschichten.

Der Artikel von Zhou X et al: "High-efficiency electrophosphorescent organic light-emitting diodes with double light-emitting layers" Applied Physics Letters, AIP, American Institute of Physics, Melville, NY, US, Bd. 81, Nr. 21,18, November 2002, Seiten 4070-4072 beschreibt die Vorteile, welche sich aus einer Dotierung der Ladungsträgertransportschichten hinsichtlich einer verbesserten Leuchteffizienz ergeben.

Zusammenfassung der Erfindung

Aufgabe der Erfindung ist es, ein Licht emittierendes Bauteil mit mehrerer organischen Bauelementen, die Licht unterschiedlicher Farbe aussendend gebildet sind, zu schaffen, bei dem für verschiedenfarbige organische Bauelemente eine hohe Effizienz der Lichterzeugung und der Lichtauskopplung erreicht ist und welches mit verminderten Aufwand herstellbar ist.

Diese Aufgabe wird erfindungsgemäß durch ein Licht emittierendes Bauteil nach dem unabhängigen Anspruch 1 gelöst.

Die Erfindung umfasst den Gedanken, ein Licht emittierendes Bauteil mit mehreren organischen Bauelementen vorzusehen, die Licht unterschiedlicher Farbe aussendend gebildet sind, wobei :

- die mehreren organischen Bauelemente jeweils einen zwischen einer Elektrode und einer Gegenelektrode angeordneten Stapel organischer Schichten aufweisen, welcher einen Löcher transportierenden Schichtbereich, einen Elektronen transportierenden Schichtbereich und einen zwischen dem Löcher transportierenden und dem Elektronen transportierenden Schichtbereich gebildeten Licht emittierenden Schichtbereich umfasst;
- eine Dicke des Löcher transportierenden und eine Dicke des Elektronen transportierenden Schichtbereiches die jeweils für alle der mehreren organischen Bauelemente gleich ist;
- der Licht emittierende Schichtbereich eine Emissionszone umfasst; und
- die mehreren organischen Bauelementen jeweils als ein top-emittierendes Bauelement ausgeführt sind;

und wobei

a) für einen Abstand $L_M$ zwischen der Emissionszone und einer dem Licht emittierenden Schichtbereich zugewandten Oberfläche der Elektrode / Gegenelektrode für alle der mehreren organischen Bauelemente gilt:

$$L_M < L_{Mmax} = L_{met} + 0.1 * L_{met}$$

$$L_M > L_{Mmin} = (L_{met} - L_{pen}) - 0.1 * (L_{met} - L_{pen})$$

mit

$$L_{pen} = \ln(100) * \lambda_{max} / (4\pi * k_{met})$$

$$L_{met} = (m + 1/2) * \lambda_{max} / (2 * n_{org}^M), \qquad m = 0, 1, 2, \ldots,$$

wenn die Elektrode / Gegenelektrode aus einem metallischen Elektrodenmaterial ist, wobei $\lambda_{max}$ die Emissionswellenlänge eines Intensitätsmaximums eines Photoluminszenzspektrums für den Licht emittierenden Schichtbereich, $n_{org}^M$ der Realteil des Brechungsindex bei der Emissionswellenlänge $\lambda_{max}$ für einen Bereich des Stapels organischer Schichten zwischen der Emissionszone und der dem Licht emittierenden Schichtbereich zugewandten Oberfläche der Elektrode / Gegenelektrode aus dem metallischen Elektrodenmaterial und $k_{met}$ der Imaginärteil des Brechungsindex des metallischen Elektrodenmaterials bei der Emissionswellenlänge $\lambda_{max}$ sind;

und wobei weiterhin

b) für ein Abstand $L_D$ zwischen der Emissionszone und der dem Licht emittierenden Schichtbereich zugewandten Oberfläche der Elektrode / Gegenelektrode für alle der mehreren organischen Bauelemente gilt:

$$L_D < L_{Dmax} = L_{pi/2} + (\lambda_{max}/(\pi*555nm) * L_{pi/2}$$

$$L_D > L_{Dmin} = L_0 - (\lambda_{max}/(\pi*555nm) * L_0$$

mit

$$L_0 = ((m+1) * \lambda_{max} / 2 - L_{die} * n_{die}) / n_{org}^D$$

$$L_{pi/2} = (m + 1/2) * \lambda_{max} / (2 * n_{org}^D), \qquad m = 0, 1, 2, \ldots,$$

wenn die Elektrode / Gegenelektrode aus einem dielektrischen Elektrodenmaterial ist, wobei $L_{die}$ eine Schichtdicke der dielektrischen Elektrode / Gegenelektrode, $n_{die}$ der Realteil des Brechungsindex bei der Emissionswellenlänge $\lambda_{max}$ für das dielektrischen Elektrodenmaterial und $n_{org}^D$ der Realteil des Brechungsindex bei der Emissionswellenlänge $\lambda_{max}$ für einen Bereich des Stapels organischer Schichten zwischen der Emissionszone und der dem Licht emittierenden Schichtbereich zugewandten Oberfläche der Elektrode / Gegenelektrode aus dem dielektrischen Elektrodenmaterial sind.

Mit der Erfindung ist die Möglichkeit geschaffen, mittels definierter Abstimmung der Schichtdicke des Licht emittierenden Schichtbereiches eine Optimierung der Lichtauskopplung für verschiedenfarbige organische Bauelemente zu erzielen, insbesondere rote, grüne und blaue OLED-Strukturen. Es wird die Lichtauskopplung für Anzeige- oder Beleuchtungsanwendungen für alle implementierten Farben optimiert, ohne dass eine weitere Auskopplungsmaßnahme außerhalb des jeweiligen Stapels organischer Schichten hierbei erforderlich ist, Die Dicken der restlichen Schichtbereiche außerhalb des Licht emittierenden Schichtbereiches, nämlich für den Elektronen transportierenden und den Löcher transportierenden Schichtbereich, sind für alle organischen Bauelemente gleich. Dies vereinfacht die Herstellung des auf organischen Bauelementen basierenden Bauteils, da aufwendige Maskieruingsschritte nur für die Abscheidung des Licht emittierenden Scbichtbereiches notwendig sind, nicht aber für die anderen Fmiktionsschichten im jeweiligen Stapel organischer Schichten.

Der Licht emittierende Schichtbereich kann Elektronen und / oder Löcher transportierend ausgeführt sein, indem ein oder mehrere Materialien verwendet werden, die als Ladungsträger Elektronen und / oder Löcher transportieren.

Bei einer Fortbildung der Erfindung kann vorgesehen sein, dass der maximale Abstand $L_{Mmax}$ unter Verwendung eines niedrigsten Brechungsindex $n_{org}^M$ (min) für den Stapel organischer Schichten und der minimale Abstand $L_{Mmin}$ unter Verwendung eines höchsten Brechungsindex $n_{org}^M$ (max) für den Stapel organischer Schichten wie folgt ermittelt werden:

$$L_M < L_{Mmax} = (m + 1/2) * \lambda_{max} / (2 * n_{org}^M (min))$$
$$+ 0.1 * (m + 1/2) * \lambda_{max} / (2 * n_{org}^M (min)), \quad m = 0, 1, 2, \ldots,$$

$$L_M > L_{Mmin} = ((m + 1/2) * \lambda_{max} / (2 * n_{org}^M (max)) - L_{pen})$$
$$- 0.1 * ((m + 1/2) * \lambda_{max} / (2 * n_{org}^M (max)) - L_{pen})$$

mit

$$L_{pen} = \ln(100) * \lambda_{max} / (4\pi * k_{met}),$$

wenn sich der Brechungsindex $n_{org}^{M}{}'$ bei der Emissionswellenlänge $\lambda_{max}$ für den Bereich des Stapels organischer Schichten zwischen der Emissionszone und der dem Licht emittierenden Schichtbereich zugewandten Oberfläche der Elektrode / Gegenelektrode aus dem metallischen Elektrodenmaterial ändert, wobei $n_{org}^{M}$ (min) $\leq n_{org}^{M} \leq n_{org}^{M}$ (max) gilt.

Bei einer weiteren Fortbildung kann vorgesehen sein, dass der maximale Abstand $L_{Dmax}$ unter Verwendung eines niedrigsten Brechungsindex $n_{org}^{D}$ (min) des Stapels organischer Schichten und der minimale Abstand $L_{Dmin}$ unter Verwendung eines höchsten Brechungsindex $n_{org}^{D}$ (max) für den Stapel organischer Schichten wie folgt ermittelt werden:

$$L_D < L_{Dmax} = L_{pi/2} + (\lambda_{max}/(\pi * 555nm) * L_{pi/2}$$

$$L_D > L_{Dmin} = L_0 - (\lambda_{max}/(\pi * 555nm) * L_0$$

mit

$$L_0 = ((m+1) * \lambda_{max} / 2 - L_{die} * n_{die}) / n_{org}^{D}(max)$$

$$L_{pi/2} = (m + 1/2) * \lambda_{max} / (2 * n_{org}^{D}(min)), \qquad m = 0, 1, 2, \ldots,$$

wenn sich der Brechungsindex $n_{org}^{D}$ bei der Emissionswellenlänge $\lambda_{max}$ für den Bereich des Stapels organischer Schichten zwischen der Emissionszone und der dem Licht emittierenden Schichtbereich zugewandten Oberfläche der Elektrode / Gegenelektrode aus dem dielektrischen Elektrodenmaterial ändert, wobei $n_{org}^{D}$ (min) $\leq n_{org}^{D} \leq n_{org}^{D}$ (max) gilt.

Um eine möglichst große Flexibilität bei der Optimierung der Schichtdicken des Elektronen transportierenden Schichtbereiches und des Löcher transportierenden Schichtbereiches zu erhalten, kann eine Fortbildung der Erfindung vorsehen, den Elektronen transportierenden Schichtbereich und / oder den Löcher transportierenden. Schichtbereich vollständig oder teilweise aus dotierten Schichten zu bilden. Die Dotierung erhöht die Leitfähigkeit eines dotierten Teils der jeweiligen Schichtbereiche, derart, dass bei Variation der Schichtdicke eines dotierten Teils die zum Ladungsträgertransport benötigte Spannung nicht oder nur unwesentlich erhöht wird.

Eine Weiterbildung der Erfindung kann vorsehen, die Menge des abgestrahlten Lichts mit Hilfe weiterer Maßnahmen zusätzlich gesteigert werden, beispielsweise mittels einer oder mehrerer Auskoppelschichten auf dem Substrat und / oder einer transparenten Deckelektrode. Vorteilhaft werden die hierfür benötigten zustätzlichen Strukturen ebenfalls für die verschiedenen, Licht unterschiedlicher Farbe aussendenden Bauelemente in jeweils gleicher Art ausgeführt.

Für die top-emittierende OLED wird mittels der beiden Elektroden, die den Stapel organischer Schichten einschließen, eine Mikrokavität gebildet. Dies lässt sich mittels bloßer Betrachtung der Variation des Brechungsindex in den einzelnen Schichten verstehen. Die optische Länge dieser Mikrokavität ist im Regelfall kürzer als die Wellenlänge des im Licht emittierenden Schichtbereich erzeugten Lichtes und auch kürzer als die Kohärenzlänge. Aus diesem Grunde spielen durch den Schichtstapel verursachte Interferenzeffekte bei der Ausbreitung und der Auskopplung des Lichtes eine entscheidende Rolle. Auch wenn in Ausnahmefällen die optische Länge der Mikrokavität größer als die Wellenlänge des emittierten Lichts ist, kann Interferenz auftreten.

Die Vorteile der Erfindung ergeben sich auch, wenn das Bauteil neben den organischen Bauelementen, die gemäß den obigen Definitionen gebildet sind, zusätzlich organische Bauelemente umfaßt, für die die Lage der Emissionszone nicht erfüllt sind. Bei dem Bauteil weisen jedoch weiterhin alle organischen Bauelemente eine einheitliche Dicke des Löcher transportierenden und eine einheitliche Dicke des Elektronen transportierenden Schichtbereiches auf, wobei sich diese beiden Dicken selbstverständlich unterscheiden können.

Wenn die Emissionszone an der Grenze des Licht emittierenden Schichtbereiches zu dem Elektronen transportierenden Schichtbereiche gebildet ist, entspricht die Dicke des Elektronen transportierenden Schichtbereiches der Dicke, die sich aus der Elektrontransportschicht und weiteren Schichten benachbart zu der Elektrontransportschicht ergibt. In gleicher Weise entspricht die Dicke des Löcher transportierenden Schichtbereiches der Dicke, die sich aus der Löchertransportschicht und weiteren Schichten benachbart zu der Löchertransportschicht ergibt, wenn die Emissionszone an der Grenze des Licht emittierenden Schichtbereiches zu dem Löcher transportierenden Schichtbereiche gebildet ist.

Für ein Emittermaterial, welches Licht einer bestimmten Wellenlänge emittiert, gibt es hinsichtlich der Effizienz der Lichtverwertung durch Lichtauskopplung eine optimale Position der Emissionszone innerhalb des Licht emittierenden Schichtbereiches. Allein durch die Position der Emissionszone wird die Abstrahlcharakteristik des organischen Bauelementes optimiert und so möglichst viel Licht ausgekoppelt, was zu einer signifikanten Effizienzverbesserung im Vergleich zu einem nicht optimierten Bauelement fuhrt. Der jeweilige optimale Aufbau der Schichten hängt vom Reflexionsvermögen, der Absorption und den Brechungsindizes der Materialien der Elektroden, des Substrats und der einzelnen Schichten im Stapel organischer Schichten sowie von dem Spektrum des mittels Ladungsträgerrekombination erzeugten Lichtes ab. Daraus ergibt sich, dass der Aufbau des Schichtstapels und die optimale Position der Emissionszone in der Mikrokavität für unterschiedlich organische Bauelemente, welche Licht der drei Grundfarben emittieren, verschieden sind.

Mit Hilfe der Transfermatrix-Theorie (siehe O. S. Heavens: Optical Properties of Thin Solid Films, Dover Publications Inc., 1991) lassen sich optimalen Abstände der Emissionszone zu den beiden Elektroden für alle organischen Bauelemente ermitteln, die Licht unterschiedlicher Farben emittieren. Als Beispiel (nicht Teil der Erfindung) sei hier die optimale Position der Emissionszone für rote, grüne und blaue bottom-emittieretlde OLEDs auf Glassubstraten mit einem 90nm dicken Grundkontakt aus ITO und einer 100nm dicken Metallelektrode aus Aluminium angeführt: Bei einem rotem Emitterrnaterial mit einem Emissionsmaximum bei 620nm sollte die Emissionszone einen Abstand von 85nm zur ITO Schicht und von 75nm zum Metallkontakt haben. Bei einem grünen Emittermaterial mit einem Emissionsmaximum bei 511nm sollte die Emissionszone einen Abstand von 60nm zur ITO-Schicht und von 65nm zum Mctallkontakt haben. Bei einem blauen Emitter mit einem Emissionsmaximum bei 450nm sollte die Emissionszone einen Abstand von 50nm oder 195nm (2. Maximum) zur ITO-Schicht und von 60nm (1. Maximum) zum Metallkontakt haben.

Eine zusätzliche Komplikation ergibt sich bei dem blauen Emittermaterialien dadurch, dass die erzielte Leuchtdichte für die oben genannten Abstände zwar optimal ist, die Farbkoordinaten jedoch stark ins Grüne schieben (x > 0.16; y > 0.20). Die Ursache hierfür ist die zunehmende Empfindlichkeit des menschlichen Auges beim Verschieben des Lichtspektrums in Richtung von 550nm aufgrund des Einflusses der Mikrokavität. Für viele Anwendungen wird jedoch eine gesättigte Blaukomponente benötigt. Deutlich bessere Farbkoordinaten (x=0.14; y=0.20), bei vertretbaren Effizienzeinbußen, ergeben sich bei einem Abstand von 35nm oder 160nm (2. Maximum) zur ITO-Schicht und von 60nm zum Metallkontakt.

Die Erfindung ermöglicht in einer Ausführungsform eine einfache Produktion von vollfarbigen OLED-Displays oder -Beleuchtungseinrichtungen, bei denen die roten, grünen und blauen organischen Bauelemente aus den selben Materialien und mit den selben Schichtdicken hergestellt sind. Damit die gewünschte Farbe des einzelnen Pixel realisiert werden kann, muss lediglich das Material der Licht emittierenden Schicht variiert werden. Das bedeutet, dass eine Maskierung der unterschiedlich Farbpixel lediglich während der Herstellung der drei Licht emittierenden Schichten notwendig ist, während die restlichen organischen Schichten ohne separate Maskierungsschritte mit einem hohen Durchsatz hergestellt werden können. Hierbei kann dann auch die Schichtdicke der Licht emittierenden Schicht für die jeweilige Farbe angepasst werden.

Beispielsweise wird eine Mischschicht aus 4,4',4''-tris(N-carbazolyl)-triphenylamine (TCTA) und tris(2-phenylpyridine) iridium (Ir(ppy)$_3$), die als grüne Licht emittierende Schicht verwendet werden kann, vorzugsweise Löcher transportieren, d.h. die Licht emittierende Schicht ist Löcher transportierend gebildet, während eine grüne Licht emittierende Schicht aus Tris-(8-hydroxyquinolin) Aluminium (Alq) ausschließlich Elektronen leitende Eigenschaften hat, d.h. die Licht emittierende Schicht ist Elektronen transportierend gebildet. Für die Lage der Emissionszone innerhalb der Licht emittierenden Schicht bedeutet dies, dass die Ladungsträgerrekombination im ersten Fall (TCTA) im Bereich der Grenzschicht zum Elektronen transportierenden Schichtbereich liegt und im zweiten Fall (Alq) im Bereich der Grenzschicht zum Löcher transportierenden Schichtbereich stattfinden wird. Hierdurch kann mit der richtigen Wahl der Ladungsträgertransporteigenschaft und der Dicke der Licht emittierenden Schicht die Rekombinationszone der Ladungsträger, nämlich die Emissionszone, an die optimale Position im Stapel organischer Schichten geschoben werden und so die Lichtauskopplung aus der Mikrokavität auf die jeweils gewünschte Farbe abgestimmt werden.

Eine weitere Möglichkeit zur Abstimmung der Emissionszone auf die Mikrokavität bietet der Einsatz einer Kombination von vorzugsweise Löcher und vorzugsweise Elektronen transportierenden Licht emittierenden Schichten (DE 102 24 021 A1, EP 1 508 176 A2).

Wird von den oben erwähnten optimalen Positionen der Emissionszone in der Mikrokavität ausgegangen, so hätte das im Regelfall extrem dicke Licht emittierende Schichten zur Folge. Weiterhin lässt sich die Löchertransportschicht der grünen OLED nicht optimieren und würde dadurch deutlich an Effizienz einbüßen. Der OLED-Stapel (nicht Teil der Erfindung) auf einem Glassubstraten mit einer 90nm dicken ITO-Grundelektrode würde eine Löchertransportschicht (HTL) von 85nm und eine Elektronentransportschieht (ETL) von 50nm aufweisen: Die Elektronen leitende, rotes Licht emittierende Schicht mit einem Emissionsniaximum bei 620nm müsste 15nm dick sein. Die grünes Licht emittierende Schicht mit einem Emissionsmaximum bei 511nm ist vorzugsweise eine Doppelemitterschicht bestehend aus einer 5nm dicken Elektronen leitenden Schicht und einer 15nm dicken Löcher leitenden Schicht. Die Löcher leitende, blaues Licht emittierende Schicht mit einem Emissionsmaximum bei 450nm müsste mindestens 75nm dick sein (2. Maximum mit guten Farbkoordinaten).

Eine deutlich bessere Lösung ist es, die Mikrokavität der OLED nicht auf die oben angegebenen optimierten Schichtdicken der drei einzelnen Grundfarben zu optimieren, sondern einen Mikzokavitätsbereich, auszuwählen, in dem die OLED noch 90% ihrer maximalen Effizienz aufweist. Dieser Bereich lässt sich sehr genau mit Hilfe der Transfermatrix-Theorie für die drei Grundfarben als Funktion des Abstandes zu den jeweiligen Elektroden bestimmen. Dieser Schichtdickenbereich läßt sich mittels der folgenden Bildungsvorschtiften beschreiben.

Zunächst wird auf den Abstand der Emissionszone zu einer Elektrode aus einem Metall eingegangen.

Hierbei besteht der folgende Zusammenhang. Da der Phasensprung einer emittierten Lichtwelle bei einer Reflexion an der Metallelektrode in guter Näherung $\pi/2$ beträgt, tritt in diesem Fall konstruktive Interferenz bei einem Abstand $L_{met}$ zwischen der Emissionszone und der dem Stapel organischer Schichten zugewandten Oberfläche der Metallelektrode auf. Es gilt:

$$L_{met} = (m + 1/2) * \lambda_{max} / (2 * n_{org}^{M})\ \text{mit } m = 0, 1, 2, \ldots,$$

$\lambda_{max}$ die Emissionswellenlänge eines Intensitätsmaximums eine Elektrolumineszenzspektrums für den Licht emittierenden Schichtbereich und $n_{org}^{M}$ der Realteil des Brechungsindex bei der Emissionswellenlänge $\lambda_{max}$ für einen organischen Schichtbereich zwischen der Emissionszonc und der dem Stapel organischer Schichten zugewandten Oberfläche der Metallelektrode sind. Die ganze Zahl m gibt die jeweilige Ordnung der Interferenz an.

Im einfachsten Fall werden Schichtdicken, verwendet, die die Bedingung der nullten Ordnung erfüllen, wobei höhere Ordnungen nicht ausgeschlossen werden. Es ist weiterhin zu beachten, dass abhängig von den Absorptionseigenschaften des Metalls der Elektrode die Lichtwelle bis zu einer gewissen Tiefe in die Elektrode eindringen kann. Eine solche Eindringtiefe $L_{pen}$ bis zu einer Abnahme der Feldstärke des Lichtfeldes auf $1/100$ wird durch den folgenden Zusammenhang gegeben:

$$L_{pen} = \ln(100) * \lambda_{max} / (4\pi * k_{met}),$$

wobei $k_{met}$ der Imaginärteil des Brechungsindex der Metallelektrode bei der Emissionswellenlänge $\lambda_{max}$ ist.

Hieraus ergeben sich als obere und untere Grenze des Schichtdickenbereiches $L_{Mmax}$ und $L_{Mmin}$ zwischen Emissionszone und der dem Stapel organischer Schichten zugewandten Oberfläche der Elektrode aus Metall:

$$L_{Mmax} = L_{met} + 0.1 * L_{met}$$

$$L_{Mmin} = (L_{met} - L_{pen}) - 0.1 * (L_{met} - L_{pen}).$$

Die Licht emittierenden Schichtbereiche für organische Bauelemente, die Licht verschiedener Farben abgeben, können jeweils auf Basis eines Matrixmaterials gebildet sein, welches Löcher und/oder Elektronen transportierend ist.

Nachfolgend wird auf den Abstand der Emissionszone zu einer Elektrode aus einem dielektrischen Material eingegangen, beispielsweise ITO.

$n_{die}$ sei der Realteil des Brechungsindex für die dielektrische Elektrode. Es bestehen die folgenden Zusammenhänge. Da der Phasensprung der im Licht emittierenden Bereich erzeugten Lichtwelle bei einer Reflexion an der dielektrischen Elektrode zwischen 0 und $\pi/2$ beträgt, tritt in diesem Fall konstruktive Interferenz in einem Abstandsbereich $L_d$ zwischen der Emissionszone und der dem Stapel organischer Schichten zugewandten Oberfläche der dielektrischen Elektrode auf, der sich wie folgt beschreiben lässt:

$$L_0 \leq L_d \leq L_{pi/2} \; ;$$

mit:

$$L_0 = ((m+1) * \lambda_{max}/2 - L_{die} * n_{die}) / n_{org}^D$$

$$L_{pi/2} = (m + 1/2) * \lambda_{max}/(2 * n_{org}^D) \qquad\qquad \text{mit } m = 0, 1, 2, \ldots,$$

wobei $n_{org}^D$ der Realteil des Brechungsindex des organischen Schichtberciches bei der Enüssionswellenlänge $\lambda_{max}$ ist, der zwischen der Emissionszone und der dem Stapel organischer Schichten zugewandten Oberfläche der dielektrischen Elektrode liegt.

Einen nicht zu vernachlässigbaren Einfluss haben die Dicke der verwendeten dielektrischen Elektrode $L_{die}$ und der Realteil des Brechungsindex $n_{die}$ der dielektrischen Elektrode bei der Emissionssionswellenlänge $\lambda_{max}$. Hieraus ergeben sich als obere und untere Grenze des Schichtdickcnbereiches $L_{Dmax}$ und $L_{Dmin}$ zwischen der Emissionszone und der dem Stapel organischer Schichten zugewandten Oberfläche der dielektrischen Elektrode:

$$L_{Dmax} = L_{pi/2} + (\lambda_{max}/(\pi * 555nm) * L_{pi/2}$$

$$L_{Dmin} = L_0 - (\lambda_{max}/(\pi * 555nm) * L_0$$

Im folgenden Beispiel (nicht Teil der Erfindung) sei für eine bottom-emittierende OLED der Stapel organischer Schichten auf einem Glassubstrat mit einem 90nm dicken ITO-Grundkontakt aufgebracht. Typische Eindringtiefen in den als Elektrode dienenden Al-Deckkontakt liegen bei etwa 30nm. Hieraus ergeben sich unter Verwendung der oben angegebenen Beziehungen folgende Abstandsbereiche der Emissionszone zur ITO-Elektrode und zur Metallelektrode:

- Die Emissionszone in der Schichtanordnung des organischen Bauelementes zum Erzeugen von rotem Licht mit einem Emissionsmaximum bei 620nm muss eine Abstand zur ITO-Elektrode zwischen 50nm, und 120nm und eine Abstand zur Metallelektrode zwischen 55nm und 100nm aufweisen.
- Die Emissionszone in der Schichtanordnung des organischen Bauelementes zum Erzeugen von grünem Licht mit einem Emissionsmaximum bei 511nm muss eine Abstand zur ITO-Elektrode zwischen 35nm und 95nm und eine Abstand zur Metallelektrode zwischen 40nm und 80nnn aufweisen.
- Die Emissionszone in der Schichtanordnung des organischen Bauelementes zum Erzeugen von blauem Licht mit einem Emissionsmaximum bei 450mn muss eine Abstand zur ITO-Elektrode zwischen 20nm und 80nm und eine Abstand zur Metallelektrode zwischen 30nm und 75nm aufweisen.

Unter Berücksichtigung der vorgenannten Abstandsbereiche für die drei Grundfarben, kann nun jeweils eine einheitliche Dicke sowohl für den Elektronen transportierenden Schichtbereich als auch für den Löcher transportierenden Schichtbereich für alle bottom-emittierenden OLEDs, die Licht in den drei Grundfarbbereichen abgeben, in einem Bauteil definiert und anschließend die Mikrokavität mittels geeigneter Auswahl der Licht emittierenden Schicht optimiert werden, wobei in diesem Beispiel ein 90nm dicker TTO-Grundkontakt gebildet ist.

Bevorzugte Ausführungsbeispiele der Erfindung

Die Erfindung wird im Folgenden anhand von Ausfuhrungsbeispielen unter Bezugnahme auf eine Zeichnung näher erläutert. Hierbei zeigen:

Fig. 1 schematische Darstellung einer Schichtanordnung für eine organische Leuchtdiode;

Fig. 2a eine grafische Darstellung der normierten Leuchtdichte in Form prozentualer Höhenlinien für eine blaue bottom-emittierende OLED in Abhängigkeit von einer Dikke eines Elektronen transportierenden Schichtbereiches und einer Dicke eines Löcher transportierenden Schichtbereiches;

Fig. 2b eine grafische Darstellung der normierten Leuchtdichte in Form prozentualer Höhenlinien für eine grüne bottom-emittierende OLED in Abhängigkeit von der Dicke des Elektronen transportierenden Schichtbereiches und der Dicke des Löcher transportierenden Schichtbereiches;

Fig. 2c eine grafische Darstellung der normierten Leuchtdichte in Form prozentualer Höbenlinien für eine rote bottom-emittierende OLED organische Schicht in Abhängigkeit von der Dicke des Elektronen transportierenden Schichtbereiches und der Dicke des Löcher transportierenden Schichtbereiches;

Fig. 3a eine grafische Darstellung der normierten Leuchtdichte in Form prozentualer Höhenlinien für eine blaue top-emittierende OLED in Abhängigkeit von der Dicke des Elektronen transportierenden Schichtbereiches und der Dicke des Löcher transportierenden Schichtbereiches;

Fig. 3b eine grafische Darstellung der normierten Leuchtdichte in Form prozentualer Höhenlinien für eine grüne top-emittierende OLED in Abhängigkeit von der Dicke des Elektronen transportierenden Schichtbereiches und der Dicke des Löcher transportierenden Schichtbereiches;

Fig. 3c eine grafische Darstellung der normierten Leuchtdichte in Form prozentualer Höhenlinien für eine rote top-emittierende OLED in Abhängigkeit von der Dicke des Elektronen transportierenden Schichtbereiches und der Dicke des Löcher transpor tierenden Schichtbereiches;

Fig. 4a eine grafische Darstellung der relativen Stromeffizienz für einen rote organische Leuchtdiode vom pin-Typ bei 100 cd/m$^2$ und 1000cd/m$^2$;

Fig. 4b eine grafische Darstellung der relativen Stromeffizienz für einen grüne organische Leuchtdiode vom pin-Typ bei 100 cd/m$^2$ und 1000cd/m$^2$; und

Fig. 4c eine grafische Darstellung der relativen Stromeffizienz für einen blaue organische Leuchtdiode vom pin- Typ bei 100 cd/m$^2$ und 1000cd/m$^2$.

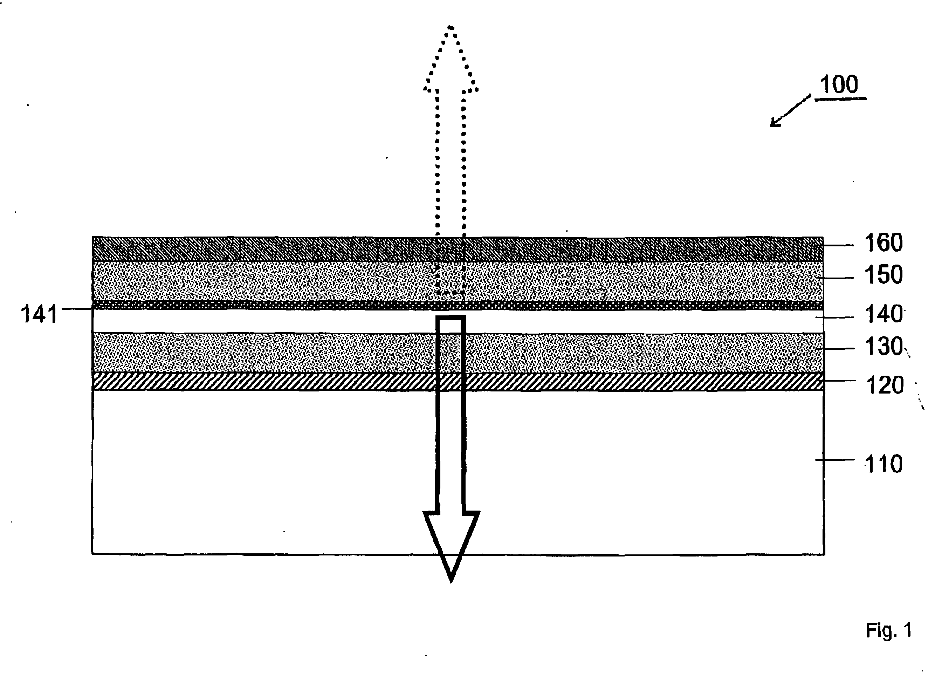

Fig. 1 eine schematische Darstellung einer Schichtanordnung 100 für eine organische Leuchtdiode, welche ein Substrat 110, ein hierauf angeordnete Grundelektrode 120, einen Ladungsträger transportierenden Schichtbereich 130, einen Licht emittierenden Schichtbereich 140 mit einer Emissionszone 141, einen weiteren Ladungsträger transportierenden Schichtbereich 150 und eine Deckelektrode 160 umfasst.

Im Folgenden werden bevorzugte Ausführungsbeispiele für Licht emittierende Bauteile mit mehrerer organischen Bauelementen erläutert, die Licht unterschiedlicher Farbe aussendend gebildet sind. Hierbei weisen die mehreren organischen Bauelemente üblicherweise jeweils einen zwischen einer Elektrode und einer Gegenelektrode angeordneten Stapel organischer Schichten auf, welcher einen Löcher transportierenden Schichtbereich, einen Elektronen transportierenden Schichtbereich und einen zwischen dem Löcher transportierenden und dem Elektronen transportierenden Schichtbereich gebildeten Licht emittierenden Schichtbereich umfasst. Eine Dicke des Löcher transportierenden und eine Dicke des Elektronen transportierenden Schichtbereiches jeweils für alle der mehreren organischen Bauelemente sind gleich ist. In dem Licht emittierenden Schichtbereich ist eine Emissionszone gebildet, in welcher die Ladungsträger, nämlich Elektronen und Löcher, unter Abgabe von Licht rekombinieren.

Zunächst wird eine Optimierung der Schichtanordnung basierend auf einer reinen Variation der Schichtdicke einer Licht emittierenden Schicht für alle drei Grundfarben erläutert, wobei die Licht emittierende Schicht aus einem Elektronen transportierenden Material besteht. Hierbei handelt es sich um die Matrix für das Licht emittierende Schicht bildende Material, in welches ein oder mehrere Emittersysteme eingelagert sind.

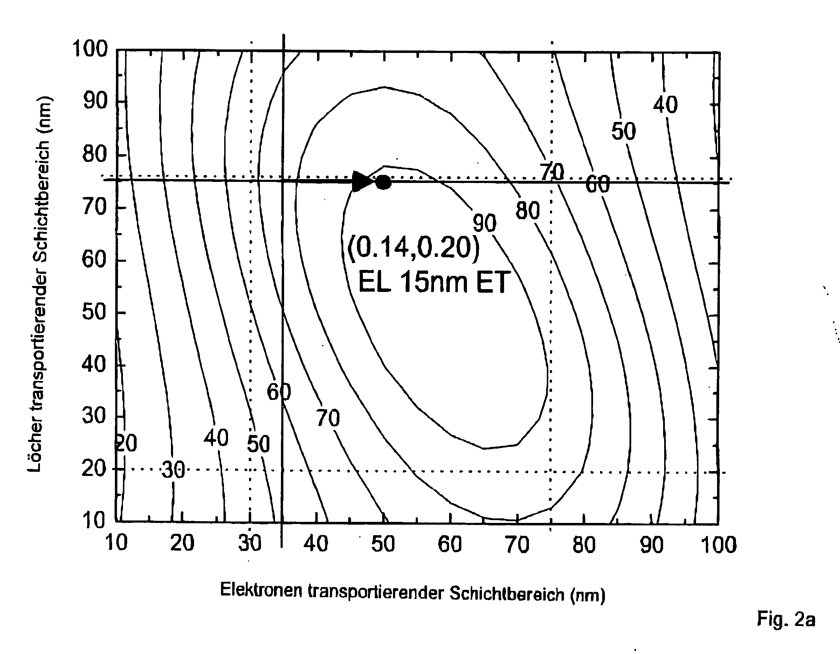

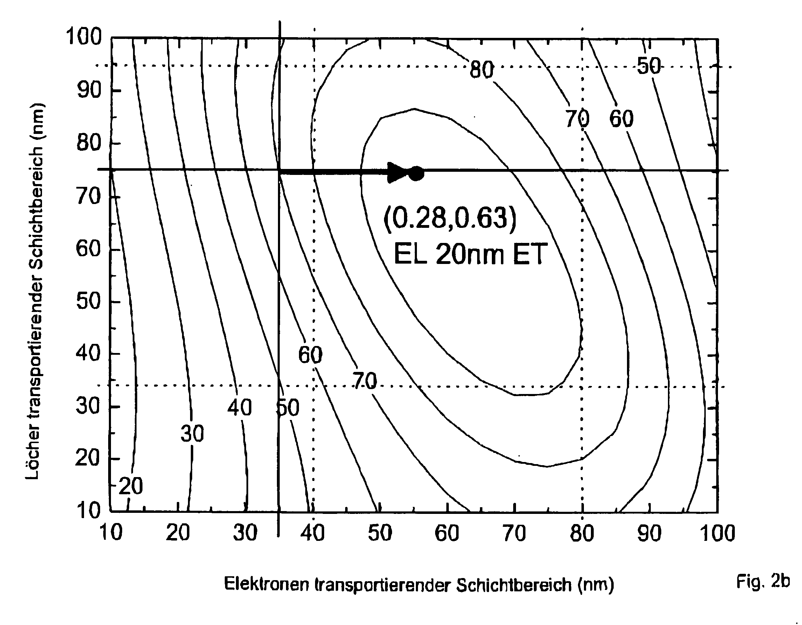

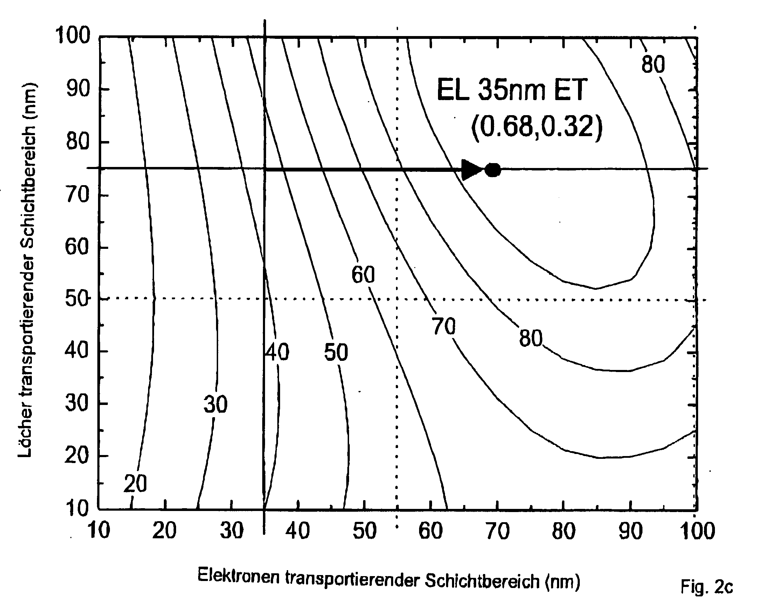

Die Fig. 2a, 2b und 2c (nicht Teil der Erfindung) zeigen eine grafische Darstellung der Leuchtdichte in Form von Höhenlinien für eine blaue, grüne oder rote Licht emittierende Schicht in einer bottomemittierenen OLED in Abhängigkeit von einer Dicke eines Elektronen transportierenden Schichtbereiches und einer Dicke eines Löcher transportierenden Schichtbereiches.

Mit Hilfe der Transfermatrix-Theorie lassen sich normierte Leuchtdichten der drei Grundfarben als Funktion des Abstands zu den jeweiligen Elektroden berechnen. In Fig. 2a sind die normierten Leuchtdichten für eine blaue bottom-emittierende OLED als prozentuale Höhenlinien dargestellt, wobei der Staple organischer Schichten zwischen einer ITO-Elektrode und einer Aluminium-Elektrode angeordnet ist. Weiterhin ist der sich aus der oben beschriebenen Bildungsvorschrift gegebene Bereich als gepunktete Linie eingezeichnet. Es ergibt sich, dass die Emissionszone einen Abstand von 20nm bis 80nm zur ITO-Elektrode und 30 bis 75nm zur Aluminium-Elektrode aufweisen muss, um noch 90% der maximalen Leuchtdichte zu erzielen. Das Material des Stapels organischer Schichten in dem Schichtbereich zwischen der Emissionszone und der ITO-Elektrode ist Löcher transportierend und das Material des Stapels organischer Schichten in dem Schichtbereich zwischen der Emissionszone und der Aluminium-Elektrode ist Elektronen transportierend.

Die Wahl des Abstandes der Emissionszone von den beiden Elektroden ist bei blauen Emittersystemen mit besonderer Sorgfalt zu betrachten, da sich die Wahl des Abstandes nicht nur auf die Leuchtdichte auswirkt, sondern auch Einfluss auf die erzielten Farbkoordinaten hat.

Bei roten und grünen Emittersystem ist der Einfluss auf die Farbkoordinaten wesentlich geringer. Aus diesem Grunde ist es von Vorteil, bei der Optimierung der Mikrokavität mit dem blaues Licht emittierenden organischen Bauelementen zu beginnen. Eine Mikrokavität mit der bei 92% der maximalen Leuchtdichte vertretbare blaue Farbkoordinaten von (x=0.14 / y=0.20) erzielt werden können, ist gegeben, wenn die Emissionszone zur ITO-Elektrode einen Abstand von 75nm und zur Aluminium-Elektrode einen Abstand von 50nm hat. Da es sich bei dem Material für das blaue Emittersystem um ein Elektronen transportierendes Material handelt, muss die Dicke der Licht emittierenden Schicht bei der Abstandsbemessung zur Aluminium-Elektrode mit berücksichtigt werden. Bei einer 15nm dicken Licht emittierenden Schicht ergeben sich dann eine optimale Dicke des Elektronen transportierenden Schichtbereiches von 35nm und eine optimale Dicke des Löcher transportierenden Schichtbereiches von 75nm.

Die Dicken der Ladungsträgertransportschichten, einschließlich möglicher Zwischenschichten, wird anschließend für die rotes oder grünes Licht emittierenden organischen Bauelemente konstant gehalten. Die Dicke und die Ladungsträgertransporteigenschaft, nämlich Elektronen transportierende oder Löcher transportierende Ausbildung, der jeweiligen Licht emittierende Schicht für rotes und grünes Licht wird variiert, um die Mikrokavität auf die jeweilige Farbe so abzustimmen, dass mindestens 90% der maximalen Leuchtdichte erreicht wird.

Wie in Fig. 2b dargestellt, werden mindestens 90% der maximalen Leuchtdichte beispielsweise für eine grünes Licht emittierende, Elektronen transportierende Schicht erreicht, wenn deren Dicke 20nm beträgt. Mit dieser Dicke kann 96% der maximalen Leuchtdichte mit Farbkoordinaten von (x=0.28 / y=0.63) erzielt werden. Für eine rotes Licht emittierende, Elektronen transportierende Schicht mit einer Dicke 45nm können beispielsweise 92% der maximalen Leuchtdichte mit Farbkoordinaten von (x=0.68 / y=0.32) erzielt werden, wie sich aus Fig. 2c ergibt.

Werden anstelle der Elektronen transportierenden Licht emittierenden Materialien Löcher transportierende Materialien für die Licht emittierenden Schichten verwendet, so muss eine andere Mikrokavität mit anderen Schichtdicken verwendet werden, um die maximalen Leuchtdichten für die drei Emittersysteme und zufriedenstellende Farbkoordinaten im Blauen zu erreichen. Gleiches gilt bei der Verwendung von Licht emittierenden Schichten mit unterschiedlichen Ladungsträgertransporteigenschaften und beim Einsatz von mehrschichtigen Licht emittierenden Schichten.

Die gewählte Mikrokavität, die jeweilige Dicke der Licht emittierenden Schicht ($d_{EL}$), die Ladungsträgertransporteigenschaft (LTE), die berechneten Farbkoordinaten und Prozente der normierten Leuchtdichten sind in der nachfolgenden Tabelle 1 aufgelistet. Die Angaben betreffen eine bottom-emittierende OLED in verschiednen Ausführungen mit einer 90nm dicken ITO-Grundelektrode und einer 100nm dicken. Aluminium-Deckelektrode. ETL und HTL bezeichnen die Dicke einer Elektronentransportschicht und einer Löchertransportschicht im Stapel organischer Schichten.

Tabelle 1

| Alle Licht emittierenden Schichten sind Elektronen transportierend, Mikrokavität: | | | | HTL: 75nm | ETL: 35nm |
|---|---|---|---|---|---|
| Farbe | $d_{EL}$ | LTE | CRI-Farbkoordinaten | norm. Leuchtdichte | |
| Rot | 35nm | ET | (x=0.68 / y=0.32) | 92% | |
| Grün | 20nm | ET | (x=0.28 / y=0.63) | 96% | |
| Blau | 15nm | ET | (x=0.14 / y=0.20) | 92% | |
| Alle Licht emittierenden Schichten sind Löcher transportierend, Mikrokavität: | | | | HTL: 35nm | ETL: 65nm |
| Farbe | $d_{EL}$ | LTE | CRI-Fatbkoordmaten | norm. Leuchtdichte | |
| Rot | 40nm | HT | (x=0.68 / y=0.32) | 92% | |
| Grün | 20nm | HT | (x=0.27 / y=0.64) | 100% | |
| Blau | 10nm | HT | (x=0.14 / y=0.20) | 99% | |

(fortgesetzt)

| Die Licht emittierenden Schichten umfassen Elektronen und Löcher transportierende Materialien, Mikrokavität: | | | | HTL: 55nm | ETL: 60nm |
|---|---|---|---|---|---|
| Farbe | $d_{EL}$ | LTE | CRI Farbkoordiunaten | norm. Leuchtdichte | |
| Rot | 30nm | HT | (x=0.68 / y=0.32) | 91% | |
| Grün | 15nm | HT | (x=0.29 / y=0.63) | 98% | |
| Blau | 10nm | ET | (x=0.18 / y=0.23) | 92% | |
| Die Licht emittierenden Schichten umfassen Elektronen und Löcher transportierende Materialien und die Licht emittierende Schicht ist ein Doppelschicht, Mikrokavität: | | | | HTL: 55nmn | ETL: 55nm |
| Farbe | $d_{EL}$ | LTE | CRI-Farbkoorditaten | norm. Leuchtdichte | |
| Rot | 20nm / 20nm | ET / HT | (x=0.68 / y=0.32) | 99% | |
| Grün | 10mm | ET | (x=0.27 ; y=0,64) | 100% | |
| Blau | 10nm | ET | (x=0.14 ; y=0.20) | 97% | |

Im Folgenden wird als Ausführungsbeispiel eine Optimierung einer top-emittierenden OLED mit einer 100nm dicken Aluminium-Gnmdelektrode und einer 20nm dünnen Cr-Deckelektrode erläutert.

Die Optimierung erfolgt mittels Variation der Dicke der Licht emittierende Schicht mit unterschiedlichen Ladungsträgertransporteigenschaften und Verwendung von doppelschichtigen Licht emittierenden Schichten. Unter Berücksichtigung der oben beschriebenen Bildungsvorschriften für die Abstandsbereiche für die drei Grundfarben, kann nun eine gemeinsame Dicke sowohl für Elektronentransportschicht und als auch die Löcheriranspvrtschicht top-emittierende OLEDs in einem Bauteil, welche blaues, grünes oder rotes Licht emittieren, definiert werden, so dass anschließend die Mikrokavität mittels geeigneter Auswahl der Dicke der jeweiligen Licht emittierenden Schicht und deren Ladungsträgertransporteigenschaft optimiert werden kann. Typische Eindringtiefen in die Aluminium-Grundelektrode betragen etwa 30nm, und bei der Cr-Deckelektrode beträgt der Wert etwa 55nm. Aus Gründen der Vereinheitlichung wird bei der Berechnung der Eindringtiefe in die dünne Cr-Deckelecktrode die Eindringtiefe in das Volumenmaterial verwendet, auch wenn dieser Kontakt nur 20nm dünn ist.

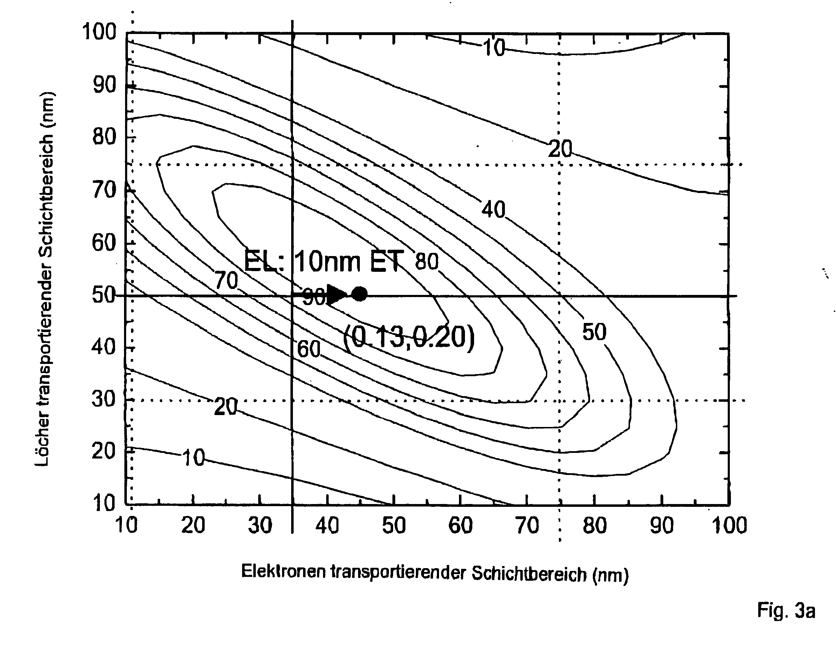

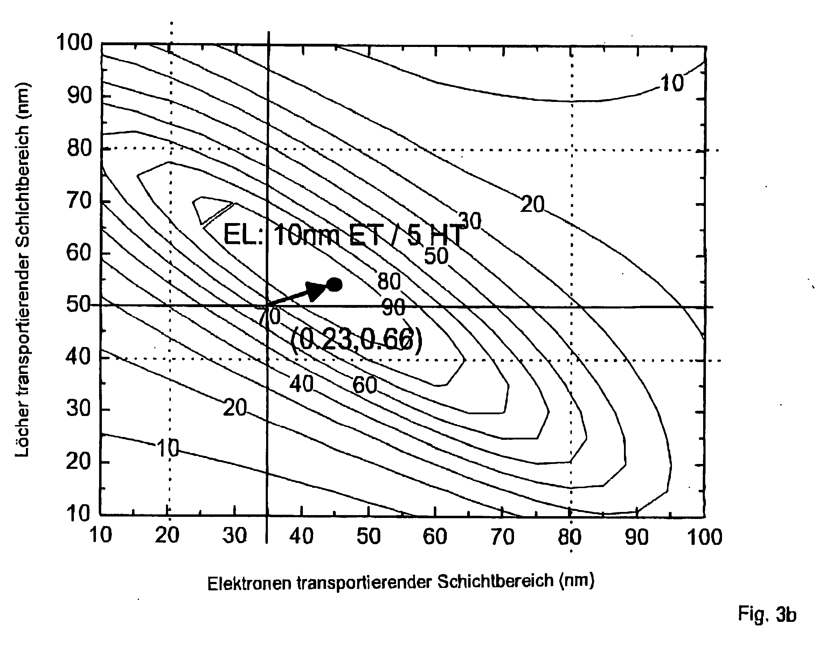

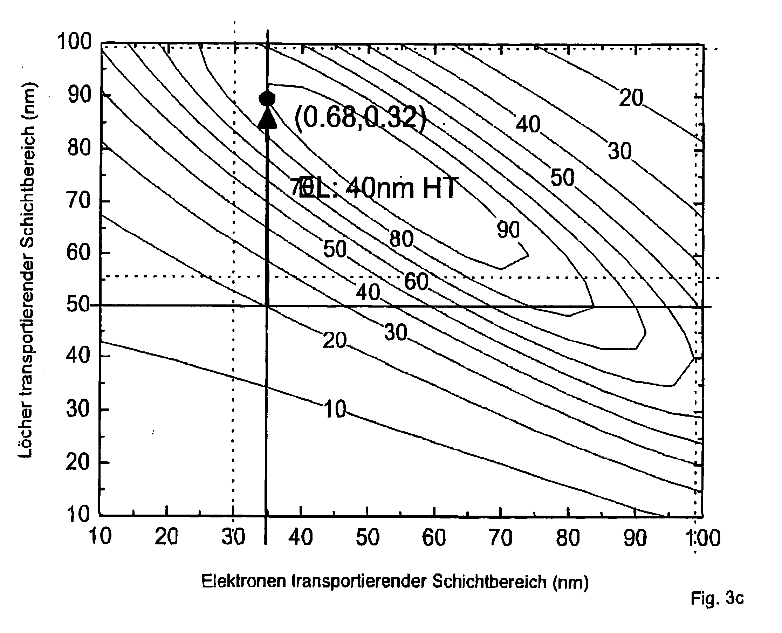

Mit Hilfe der Tirausfermatrix-Theorie lassen sich nun die normierten Leuchtdichten der drei Grundfarben als Funktion des Abstandes zu den jeweiligen Elektroden berechnen. In den Fig. 3a, 3b und 3c sind die normierten Leuchtdichten in Form prozentualer Höhenlinien dargestellt. Weiterhin ist der sich aus der oben beschriebenen Bildungsvorsehrift ergebende Grenzwerte für die Dicke des Löcher transportierenden Bereiches und die Dicke des Elektronen transportierenden Bereiches als gepunktete Linie eingezeichnet.

Eine Mikrokavität, mit der bei 98% der maximalen Leuchtdichte vertretbare blaue Farbkoordinaten von (x=0.13 / y=0.20) erzielt werden können, ist gegeben, wenn die Emissionszone bei dem blaues Licht emittierenden Stapel organischer Schichten mit einem Emissionsmaximum bei 450nm einen Abstand von 50nm zur Aluminium-Elektrode und eine Abstand von 45nm zur Cr-Elektrode hat.

Bei Wahl eines Elektronen transportierenden Materials für die Licht emittierende Schicht muss, wie aus Fig. 3a hervorgeht, die Dicke der Licht emittierenden Schicht für den Abstand zur Aluminium-Elektrode mit berücksichtigt werden. Bei einer 10nm dicken Licht emittierenden Schicht ergibt sich somit eine optimale Dicke für die Elektronentransportsehicht, einschließlich eventueller weiterer organischer Schichten auf dieser Seite der Emissionszone, von 35nm und eine optimale Dicke für die Löcheriransportschicht, einschließlich eventueller weiterer organischer Schichten auf dieser Seite der Emissionszone, von 50nm. Die Dicken der Ladungsträgertransportschichten, einschließlich weiterer möglicher Zwischenschichten, wird wieder für das rotes Licht emittierende Bauelement und das grünes Licht emittierende Bauelement konstant gehalten, und die rotes und die grünes Licht emittierende Schicht werden variiert, um die Mikrokavität auf die jeweilige Farbe so abzustimmen, dass mindestens 90% der maximalen Leuchtdichte erreicht werden.

Wie sich aus Fig. 3b ergibt, wird dieses für eine doppelschichtige, grünes Licht emittierende Schicht mit einem Emissionsmaximum bei 511nm erreicht, wenn die Dicke der Elektronen transportierend gebildeten, Licht emittierenden Schicht 10nm und die der Löcher transportierend gebildeten, Licht emittierenden Schicht 5nm betragen. Mit dieser Dicke können 98% der maximalen Leuchtdichte mit Farbkoordinaten, von (x=0.23 / y=0.66) erzielt werden.

Für eine 40nm dicke und rotes Licht emittierende Schicht mit einem Emissionsmaximuni bei 620nm, die Elektronen transportierend gebildet ist, können 92% der maximalen Leuchtdichte mit Farbkoordinaten von (x=0.68 / y=0.32) erzielt werden, wie sich aus Fig. 3c ergibt.

Obwohl die hier aufgezeigten Beispiele sich ausschließlich auf das erste Interferenzmaximum nicht invertierter OLEDs beziehen, lässt sich dasselbe Prinzip auch für höhere Maxima und invertierte OLEDs anwenden.

Bei einem anderen Beispiel (nicht Teil der Erfindung) wird zum Herstellen eines Bauteils mit mehreren organischen, jeweils als eine OLED ausgeführten Bauelementen zunächst ein mit ITO beschichtetes Glassubstrat strukturiert und gereinigt. Die Dicke der ITO-Schicht, die als Elektrode dient, beträgt etwa 90nm bei einem Flächenwiderstand von etwa 20Ω/sq. Hierauf folgende Schichten wurden nacheinander mittels thermischen Verdampfens im Vakuum aufgebracht, wobei das Vakuum nicht gebrochen wurde. Es wurden die folgenden Schichten aufgebracht:

1) 70nm bis 95nm N,N,N',N'-Tetrakis(4-methoxyphenyl)-benzidin (MeO-TPD) dotiert mit 2,3,5,6-Tctrafluoro-7,7,8,8-tetracyanoquinodimethan (F4-TCNQ) im molekularen Verhältnis von 50:1 als p-doticrte Löchertransportschicht;
2) 10nm 2,2',7,7'-Tetrakis-(N,N-diphenylamino)-9,9'-spirobifluoren (Spiro-TAD) als Zwischenschicht;
3) Licht emittierende Schicht (mit rotem, grünem oder blauem Emittersystem);
4) 10nm Bathophenanthrolin (Bphen) als Zwischenschicht;
5) 25nm bis 45nm Bphen dotiert mit Cs im molekularen Verhältnis von 1:1 als n-dotierte Elektronentransportschicht;
6) 100nm Aluminium als Kathode;

Für die Licht emittierenden Schichten wurden die folgenden Materialien verwendet: Rot - 1,3,5-tri(phenyl-2-benzimidazol)-benzen: tris(1-phenylisoquinolin) iridium (III) (TPBI:ADS068RE) / 45nm (Elektronen transportierend); Grün - TPBI:Ir(ppy)$_3$ / 25 nm (Elektronen transportierend) und Blau - 9,10-bis (9,9-spiro bifluoren-2-yl) anthracen (S-ANT)/ 20 nm (Elektronen transportierend).

Diese organischen Bauelemente, welche rotes, grünes oder blaues Licht emittieren, weisen ein jeweiliges Emissionsmaximum bei etwa 620nm, 511nm und 450nm auf. Bei einer angelegten Spannung von 3.V, 2.7V und 3.6 V beträgt die Emissionshelligkeit bei Messung durch die ITO-Grundelektrode hindurch 1000cd/m2.

Um die mittels der oben angegebenen Bildungsvorschriften ermittelten Werte (vgl. Tabelle1) zu überprüfen, wurden die Bauelement mit der vorangehend beschriebenen Struktur untersucht. Für alle drei Bauelemente wurde eine Schichtdickenvariation von 70nm bis 95nm für die Löchertransportschicht und von 25nm bis 45nm für die Elektronentransportschicht gefertigt. Wie mit Hilfe der Transfermatrix-Theorie berechnet, ergibt sich für alle drei Farben bei einer Schichtdicke von 75nm für die Löchertransportschicht und von 35nm für die Elektronentransportsehicht ein Wert von deutlich über 90% der maximalen Effizienz. Dies gilt sowohl bei einer Helligkeit von 100 cd/m$^2$, als auch bei einer Helligkeit von 1000cd/m$^2$.

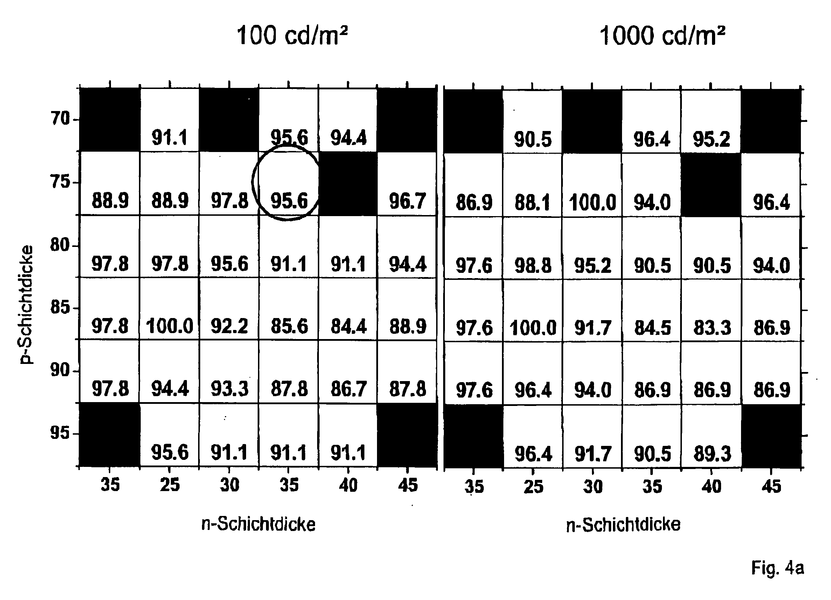

In Fig. 4a ist die relative Stromeffizienz für einen rote pin-OLED dargestellt. Für eine Schichtdicke von 75nm für die Löchertransportschicht und von 35nm für die Elektronentransportschicht ergeben sich 95.6 % und 94.0 % der maximalen Stromeffizienz für 100cd/m$^2$ und 1000cd/m$^2$.

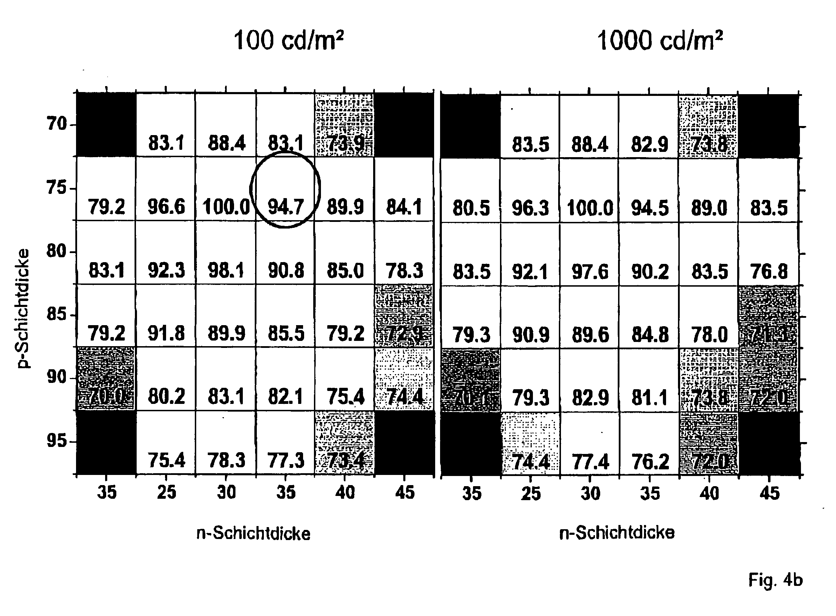

In Fig. 4b ist die relative Stromeffizienz für eine grüne pin-OLED dargestellt. Hierbei ergeben sich bei einer Schichtdicke von 75nm für die Löchertransportschicht und von 35nm für die Elektronentransportschicht für die maximale Stromeffizienz Werte von 94.7% und 94.5%.

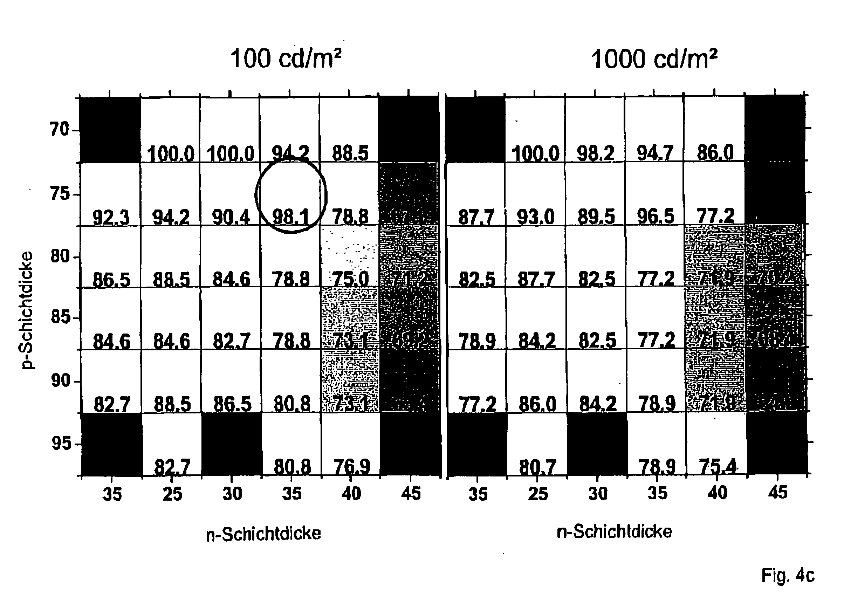

In Fig. 4c ist die relative Stromeffizienz für eine blaue pin-OLED dargestellt. Für eine Schichtdicke von 75nm für die Löchertransportschicht und von 35nm für die Elektronentransportschicht werden maximale Stromeffizienzen von 98.1% und 96.5% für 100cd/m$^2$ und 1000cd/m$^2$ erreicht.

Die in der vorstehenden Beschreibung, den Ansprüchen und den Zeichnungen offenbarten Merkmale der Erfindung können sowohl einzeln als auch in beliebiger Kombination für die Verwirklichung der Erfindung in ihren verschiedenen Ausführungsformen von Bedeutung sein.

**Patentansprüche**

1. Licht emittierendes Bauteil, insbesondere Anzeige- oder Beleuchtungseinrichtung, mit mehreren organischen Bauelementen, die Licht unterschiedlicher Farbe aussendend gebildet sind, wobei:

- die mehreren organischen Bauelemente jeweils einen zwischen einer Elektrode und einer Gegenelektrode angeordneten Stapel organischer Schichten aufweisen, welcher einen Löcher transportierenden Schichtbereich, einen Elektronen transportierenden Schichtbereich und einen zwischen dem Löcher transportierenden und dem Elektronen transportierenden Schichtbereich gebildeten Licht emittierenden Schichtbereich umfasst;
- eine Dicke des Löcher transportierenden und eine Dicke des Elektronen transportierenden Schichtbereiches jeweils für alle der mehreren organischen Bauelemente gleich ist;
- der Licht emittierende Schichtbereich eine Emissionszone umfasst; und
- die mehreren organischen Bauelementen jeweils als ein top-emittierendes Bauelement ausgeführt sind;

**dadurch gekennzeichnet, daß**

a) für einen Abstand $L_M$ zwischen der Emissionszone und einer dem Licht emittierenden Schichtbereich zugewandten Oberfläche der Elektrode / Gegenelektrode für alle der mehreren organischen Bauelemente gilt:

$$L_M < L_{Mmax} = L_{met} + 0.1 * L_{met}$$

$$L_M > L_{Mmin} = (L_{met} - L_{pen}) - 0.1 * (L_{met} - L_{pen})$$

mit

$$L_{pen} = \ln(100) * \lambda_{max} / (4\pi * k_{met})$$

$$L_{met} = (m + 1/2) * \lambda_{max} / (2 * n_{org}^M), \qquad m = 0, 1, 2, \ldots,$$

wenn die Elektrode / Gegenelektrode aus einem metallischen Elektrodenmaterial ist, wobei $\lambda_{max}$ die Emissionswellenlänge eines Intensitätsmaximums eines Photolumineszenzspektrums des Licht emittierenden Schichtbereiches, $n_{org}^M$ der Realteil des Brechungsindex bei der Emissionswellenlänge $\lambda_{max}$ für einen Bereich des Stapels organischer Schichten zwischen der Emissionszone und der dem Licht emittierenden Schichtbereich zugewandten Oberfläche der Elektrode / Gegenelektrode aus dem metallischen Elektrodenmaterial und $k_{met}$ der Imaginärteil des Brechungsindex des metallischen Elektrodenmaterials bei $\lambda_{max}$ sind; und

b) für ein Abstand $L_D$ zwischen der Emissionszone und der dem Licht emittierenden Schichtbereich zugewandten Oberfläche der Elektrode / Gegenelektrode für alle der mehreren organischen Bauelemente gilt:

$$L_D < L_{Dmax} = L_{pi/2} + (\lambda_{max}/(\pi*555nm)) * L_{pi/2}$$

$$L_D > L_{Dmin} = L_0 - (\lambda_{max}/(\pi*555nm)) * L_0$$

mit

$$L_0 = ((m+1) * \lambda_{max} / 2 - L_{die} * n_{die}) / n_{org}$$

$$L_{pi/2} = (m + 1/2) * \lambda_{max} / (2 * n_{org}^D), \qquad m = 0, 1, 2, \ldots,$$

wenn die Elektrode / Gegenelektrode aus einem dielektrischen Elektrodenmaterial der Dicke $L_{die}$ ist, wobei $n_{die}$ der Realteil des Brechungsindex bei der Emissionswellenlänge $\lambda_{max}$ für das dielektrische Elektrodenmaterial und $n_{org}^D$ der Realteil des Brechungsindex bei der Emissionswellenlänge $\lambda_{max}$ für einen Bereich des Stapels organischer Schichten zwischen der Emissionszone und der dem Licht emittierenden Schichtbereich zugewandten Oberfläche der Elektrode / Gegenelektrode aus dem dielektrischen Elektrodenmaterial sind.

2. Bauteil nach Anspruch 1, **dadurch gekennzeichnet, dass** für zumindest einen Teil der mehreren organischen Bauelemente, welche Licht einer ersten Farbe abgeben, ein oder mehrere Matrixmaterialien in dem Licht emittierenden Schichtbereich Elektronen transportierend sind.

3. Bauteil nach Anspruch 2, **dadurch gekennzeichnet, dass** für zumindest den Teil der mehreren organischen Bauelemente, welche Licht der ersten Farbe abgeben, die Emissionszone in einem Grenzflächenbereich zwischen dem Löcher transportierenden Schichtbereich und dem Licht emittierenden Schichtbereich gebildet ist.

4. Bauteil nach einem der vorangehenden Ansprüche, **dadurch gekennzeichnet, dass** für zumindest einen Teil der mehreren organischen Bauelemente, welche Licht einer zweiten Farbe abgeben, ein oder mehrere Matrixmaterialien in dem Licht emittierenden Schichtbereich Löcher transportierend sind.

5. Bauteil nach Anspruch 4, **dadurch gekennzeichnet, dass** für zumindest den Teil der mehreren organischen Bauelemente, welche Licht der zweiten Farbe abgeben, die Emissionszone in einem Grenzflächenbereich zwischen dem Elektronen transportierenden Schichtbereich und dem Licht emittierenden Schichtbereich gebildet ist.

6. Bauteil nach Anspruch 4, **dadurch gekennzeichnet, dass** für zumindest den Teil der mehreren organischen Bauelemente, welche Licht der zweiten Farbe abgeben, ein oder mehrere weitere Matrixmaterialien in dem Licht emittierenden Schichtbereich Elektronen transportierend sind.

7. Bauteil nach einem der vorangehenden Ansprüche, **dadurch gekennzeichnet, dass** für zumindest einen Teil der mehreren organischen Bauelemente der Licht emittierende Bereich mehrschichtig ausgeführt ist.

8. Bauteil nach einem der vorangehenden Ansprüche, **dadurch gekennzeichnet, dass** der Elektronen transportierende Schichtbereich eine dotierte Elektronentransportschicht umfasst.

9. Bauteil nach einem der vorangehenden Ansprüche, **dadurch gekennzeichnet, dass** der Löcher transportierende Schichtbereich eine dotierte Löchertransportschicht umfasst.

10. Bauteil nach einem der vorangehenden Ansprüche, **dadurch gekennzeichnet, dass** der Licht emittierende Schichtbereich Elektronen und / oder Löcher transportierend ausgeführt ist.

**Claims**

1. A light-emitting component, especially a display or illumination apparatus with several organic structural elements that are designed to emit light of different colors, where

- the several organic structural elements each comprise a stack of organic layers arranged between an electrode and a counterelectrode, which stack comprises a layer region transporting holes, a layer region transporting electrons and comprises a light-emitting layer region formed between the layer region transporting holes and the layer region transporting electrons;
- a thickness of the layer region transporting holes and a thickness of the layer region transporting electrons that is the same for all of the several organic structural elements;
- the light-emitting layer region comprises an emission zone; and
- the several organic structural elements are each designed as a top-emitting structural element;

**characterized in that**

a) the following is valid for an interval $L_M$ between the emission zone and a surface of the electrode /counterelectrode facing the light-emitting layer region for all of the several organic structural elements:

$$L_M < L_{Mmax} = L_{met} + 0.1 * L_{met}$$

$$L_M > L_{Mmin} = (L_{met} - L_{pen}) - 0.1 * (L_{met} - L_{pen})$$

with

$$L_{pen} = \ln(100) * \lambda_{max} / (4\pi * k_{met})$$

$$L_{met} = (m + 1 / 2) * \lambda_{max} / (2 * n_{org}^M), \qquad m = 0, 1, 2, \ldots,$$

when the electrode / counterelectrode consists of a metallic electrode material, where $\lambda_{max}$ is the emission wavelength of an intensity maximum of a photoluminescence spectrum of the light-emitting layer region, $n_{org}^M$ is the real part of the refraction index at the emission wavelength $\lambda_{max}$ for a region of the stack of organic layers between the emission zone and the surface of the electrode / counterelectrode of the metallic electrode material facing the light-emitting layer region and $k_{met}$ is the imaginary part of the refraction index of the metallic electrode material at emission wavelength $\lambda_{max}$;
and
b) the following is valid for an interval $L_D$ between the emission zone and the surface of the electrode / counterelectrode facing the light-emitting layer region for all of the several organic structural elements:

$$L_D < L_{Dmax} = L_{pi/2} + (\lambda_{max}/(\pi*555nm) * L_{pi/2}$$

$$L_D > L_{Dmin} = L_0 - (\lambda_{max}/(\pi*555nm) * L_0$$

with

$$L_0 = ((m+1) * \lambda_{max} / 2 - L_{die} * n_{die}) / n_{org}^D$$

$$L_{pi/2} = (m + 1 / 2) * \lambda_{max} / (2 * n_{org}^D), \qquad m = 0, 1, 2, \ldots,$$

when the electrode / counterelectrode consists of a dielectric electrode material with thickness $L_{die}$, where $n_{die}$ is the real part of the refraction index at emission wavelength $\lambda_{max}$ for the dielectric electrode material and $n_{org}^D$ the real part of the refraction index at emission wavelength $\lambda_{max}$ for a region of the stack of organic layers between the emission zone and the surface of the electrode / counterelectrode of the dielectric electrode material facing the light-emitting layer region.

2. The component according to Claim 1, **characterized in that** one or several matrix materials are electron-transporting in the light-emitting layer region for at least part of the several organic structural elements that emit light of a first color.

3. The component according to Claim 2, **characterized in that** the emission zone is formed in a boundary surface region between the hole-transporting layer region and the light-emitting layer region for at least the part of the several organic structural elements that emit light of the first color.

**4.** The component according to any one of the preceding claims, **characterized in that** one or several matrix materials are hole-transporting in the light-emitting layer region for at least part of the several organic structural elements that emit light of a second color.

**5.** The component according to Claim 4, **characterized in that** the emission zone is formed in a boundary surface region between the electron-transporting layer region and the light-emitting layer region for at least the part of the several organic structural elements that emit light of the second color.

**6.** The component according to Claim 4, **characterized in that** one or several other matrix materials are electron-transporting in the light-emitting layer region for at least the part of the several organic structural elements that emit light of the second color.

**7.** The component according to any one of the preceding claims, **characterized in that** the light-emitting region is designed to be multilayered for at least part of the several organic structural elements.

**8.** The component according to any one of the preceding claims, **characterized in that** the electron-transporting layer region has a doped electron transport layer.

**9.** The component according to any one of the preceding claims, **characterized in that** the hole-transporting layer region has a doped hole transport layer.

**10.** The component according to any one of the preceding claims, **characterized in that** the light-emitting layer region is designed to be electron-transporting and/or hole-transporting.

**Revendications**

**1.** Dispositif électroluminescent, en particulier dispositif d'affichage ou d'éclairage, avec plusieurs composants organiques formés de manière à émettre de la lumière de couleur différente, étant donné que ;

- les multiples composants organiques présentent chacun une pile de couches organiques disposées entre une électrode et une contre-électrode, pile qui comprend une région de couche transporteuse de trous, une région de couche transporteuse d'électrons, et une région de couche électroluminescente formée entre la région de couche transporteuse de trous et la région de couche transporteuse d'électrons ;
- une épaisseur de la région de couche transporteuse de trous et une épaisseur de la région de couche transporteuse d'électrons sont identiques pour chacun des multiples composants organiques ;
- la région de couche électroluminescente comprend une zone d'émission ; et
- les multiples composants organiques sont réalisés chacun comme composant à émission par le haut ;

**caractérisé en ce que**

a) pour un écartement $L_M$ entre la zone d'émission et une surface de l'électrode / la contre-électrode orientée vers la région de couche électroluminescente, pour tous les multiples composants organiques :

$$L_M < L_{Mmax} = L_{met} + 0.1 * L_{met}$$

$$L_M > L_{Mmin} = (L_{met} - L_{pen}) - 0.1 * (L_{met} - L_{pen})$$

avec

$$L_{pen} = \ln(100) * \lambda_{max} / (4\pi * k_{met})$$

$$L_{met} = (m + 1 / 2) * \lambda_{max} / (2 * n_{org}^{M}), \qquad m = 0, 1, 2, ...,$$

lorsque l'électrode / la contre-électrode est fabriquée en un matériau métallique, $\lambda_{max}$ étant la longueur d'onde d'émission d'un maximum d'intensité d'un spectre de photoluminescence de la région de couche électroluminescente, $n_{org}^{M}$ la partie réelle de l'indice de réfraction pour la longueur d'onde d'émission $\lambda_{max}$ pour une région de la pile de couches organiques entre la zone d'émission et la surface de l'électrode /la contre-électrode en matériau d'électrode métallique orientée vers la région de couche électroluminescente, et $k_{met}$ la partie imaginaire de l'indice de réfraction du matériau d'électrode métallique pour $\lambda_{max}$ ;
et

b) pour un écartement $L_D$ entre la zone d'émission et la surface de l'électrode / la contre-électrode orientée vers la région de couche électroluminescente, pour tous les multiples composants organiques :

$$L_D < L_{Dmax} = L_{pi/2} + (\lambda_{max}/(\pi * 555nm)) * L_{pi/2}$$

$$L_D > L_{Dmin} = L_0 - (\lambda_{max}/(\pi * 555nm)) * L_0$$

avec

$$L_0 = ((m+1) * \lambda_{max} / 2 - L_{die} * n_{die}) / n_{org}$$

$$L_{pi/2} = (m + 1 / 2) * \lambda_{max} / (2 * n_{org}^{D}), \qquad m = 0, 1, 2, ...,$$

lorsque l'électrode / la contre-électrode est fabriquée en un matériau diélectrique d'épaisseur $L_{die}$, $n_{die}$ étant la partie réelle de l'indice de réfraction pour la longueur d'onde d'émission $\lambda_{max}$ pour le matériau d'électrode diélectrique et $n_{org}^{D}$ la partie réelle de l'indice de réfraction pour la longueur d'onde d'émission $\lambda_{max}$ pour une région de la pile de couches organiques entre la zone d'émission et la surface de l'électrode / la contre-électrode en matériau diélectrique orientée vers la région de couche électroluminescente.

2. Dispositif selon la revendication 1, **caractérisé en ce que** pour au moins une partie des multiples composants organiques qui dégagent de la lumière d'une première couleur, un ou plusieurs matériaux de matrices dans la région de couche électroluminescente sont transporteurs d'électrons.

3. Dispositif selon la revendication 2, **caractérisé en ce que** pour au moins la partie des multiples composants organiques qui dégagent de la lumière de la première couleur, la zone d'émission est formée dans une région d'interface entre la région de couche transporteuse de trous et la région de couche électroluminescente.

4. Dispositif selon l'une quelconque des revendications précédentes, **caractérisé en ce que** pour au moins une partie des multiples composants organiques qui dégagent de la lumière d'une deuxième couleur, un ou plusieurs matériaux de matrices dans la région de couche électroluminescente sont transporteurs de trous.

5. Dispositif selon la revendication 4, **caractérisé en ce que** pour au moins la partie des multiples composants organiques qui dégagent de la lumière de la deuxième couleur, la zone d'émission est formée dans une région d'interface entre la région de couche transporteuse d'électrons et la région de couche électroluminescente.

6. Dispositif selon la revendication 1, **caractérisé en ce que** pour au moins la partie des multiples composants organiques qui dégagent de la lumière de la deuxième couleur, un ou plusieurs autres matériaux de matrices dans la région de couche électroluminescente sont transporteurs d'électrons.

7. Dispositif selon l'une quelconque des revendications précédentes, **caractérisé en ce que** pour au moins une partie des multiples composants organiques, la région électroluminescente est réalisée en plusieurs couches.

8. Dispositif selon l'une quelconque des revendications précédentes, **caractérisé en ce que** la région de couche transporteuse d'électrons comprend une couche de transport d'électrons dopée.

9. Dispositif selon l'une quelconque des revendications précédentes, **caractérisé en ce que** la région de couche transporteuse de trous comprend une couche de transport de trous dopée.

10. Dispositif selon l'une quelconque des revendications précédentes, **caractérisé en ce que** la région de couche électroluminescente est réalisée de manière à transporter des électrons et / ou des trous.

100

160
150
140
130
120

110

141

Fig. 1

Fig. 2a

Fig. 2b

EP 1 788 647 B1

Fig. 2c

EP 1 788 647 B1

Fig. 3a

Elektronen transportierender Schichtbereich (nm)

Löcher transportierender Schichtbereich (nm)

EL: 10nm ET
(0.13, 0.20)

10 20 40 50 60 70 80

Fig. 3b

Fig. 3c

EP 1 788 647 B1

**100 cd/m²**

| p-Schichtdicke \ n-Schichtdicke | 35 | 25 | 30 | 35 | 40 | 45 |
|---|---|---|---|---|---|---|
| 70 | ■ | 91.1 | ■ | 95.6 | 94.4 | ■ |
| 75 | 88.9 | 88.9 | 97.8 | 95.6 | ■ | 96.7 |
| 80 | 97.8 | 97.8 | 95.6 | 91.1 | 91.1 | 94.4 |
| 85 | 97.8 | 100.0 | 92.2 | 85.6 | 84.4 | 88.9 |
| 90 | 97.8 | 94.4 | 93.3 | 87.8 | 86.7 | 87.8 |
| 95 | ■ | 95.6 | 91.1 | 91.1 | 91.1 | ■ |

**1000 cd/m²**

| p-Schichtdicke \ n-Schichtdicke | 35 | 25 | 30 | 35 | 40 | 45 |
|---|---|---|---|---|---|---|
| 70 | ■ | 90.5 | ■ | 96.4 | 95.2 | ■ |
| 75 | 86.9 | 88.1 | 100.0 | 94.0 | ■ | 96.4 |
| 80 | 97.6 | 98.8 | 95.2 | 90.5 | 90.5 | 94.0 |
| 85 | 97.6 | 100.0 | 91.7 | 84.5 | 83.3 | 86.9 |
| 90 | 97.6 | 96.4 | 94.0 | 86.9 | 86.9 | 86.9 |
| 95 | ■ | 96.4 | 91.7 | 90.5 | 89.3 | ■ |

Fig. 4a

100 cd/m²  1000 cd/m²

p-Schichtdicke

| p \ n | 35 | 25 | 30 | 35 | 40 | 45 |
|---|---|---|---|---|---|---|
| 70 | | 83.1 | 88.4 | 83.1 | 73.9 | |
| 75 | 79.2 | 96.6 | 100.0 | 94.7 | 89.9 | 84.1 |
| 80 | 83.1 | 92.3 | 98.1 | 90.8 | 85.0 | 78.3 |
| 85 | 79.2 | 91.8 | 89.9 | 85.5 | 79.2 | 72.9 |
| 90 | 70.0 | 80.2 | 83.1 | 82.1 | 75.4 | 74.4 |
| 95 | | 75.4 | 78.3 | 77.3 | 73.4 | |

n-Schichtdicke

| p \ n | 35 | 25 | 30 | 35 | 40 | 45 |
|---|---|---|---|---|---|---|
| 70 | | 83.5 | 88.4 | 82.9 | 73.8 | |
| 75 | 80.5 | 96.3 | 100.0 | 94.5 | 89.0 | 83.5 |
| 80 | 83.5 | 92.1 | 97.6 | 90.2 | 83.5 | 76.8 |
| 85 | 79.3 | 90.9 | 89.6 | 84.8 | 78.0 | 71.1 |
| 90 | 70.1 | 79.3 | 82.9 | 81.1 | 73.8 | 72.0 |
| 95 | | 74.4 | 77.4 | 76.2 | 72.0 | |

n-Schichtdicke

Fig. 4b

1000 cd/m²

n-Schichtdicke

100 cd/m²

n-Schichtdicke

p-Schichtdicke

Fig. 4c

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 1425803 A1
- DE 10145492 A1
- DE 10058578 C2
- US 5554911 B2
- US 20030075714 A1
- EP 1154676 A1
- US 6541130 B2

- US 6861800 B2
- WO 2004034750 A
- US 2004164671 A1
- US 2002090449 A1
- US 20040169624 A1
- DE 10224021 A1
- EP 1508176 A2

**In der Beschreibung aufgeführte Nicht-Patentliteratur**

- **JAN BLOCHWITZ-NIMOTH et al.** 29.1: Full Color Active Matrix OLED Displays with High Aperture Ratio. *2004 SID International Symposium, Seattle, WA, May 25-27, 2004, SID International Symposium,* 25. Mai 2004, 1000-1003

- High-efficiency electrophosphorescent organic light-emitting diodes with double light-emitting layers. **ZHOU X et al.** Applied Physics Letters. American Institute of Physics, 18. November 2002, vol. 81, 4070-4072
- **O. S. HEAVENS.** Optical Properties of Thin Solid Films. Dover Publications Inc, 1991